# EUROPEAN PATENT APPLICATION

(11) **EP 2 282 351 A2**
(43) Date of publication of application: **09.02.2011**
(21) Application number: 10015127.3
(22) Date of filing: 20.01.2009
(51) Int. Cl.: H01L 31/05, H01L 31/0224

(54) **Electrical interconnection of cells within a solar cell module**

(30) Priority: 21.01.2008 JP 2008010972
(62) Divisional of application: 09250152.7
(71) Applicant: Sanyo Electric Co., Ltd., Osaka 570-8677 (JP)
(72) Inventor: Hishida, Yuji, Moriguchi-shi Osaka 570-8677 (JP)
(74) Representative: Calderbank, Thomas Roger

(57) **Abstract**

To suppress a decrease in power collection efficiency, provided is a solar cell module including: first and second solar cells arranged in a first direction; and a wiring member electrically connecting the first and second solar cells. In the solar cell module, the first and second solar cells each include a light--receiving surface receiving light, a back surface provided on the opposite side of the light-receiving surface, and p-side and n-side electrodes formed on the back surface; the wiring member is connected to the n-side electrode of the first solar cell at a first connecting point, and connected to the p-side electrode of the second solar cell at a second connecting point; and, in a planar view of the back surface, the first and second connecting points are located on a line intersecting with the first direction.

## Description

This application is based upon and claims the benefit of priority from prior Japanese Patent Application No.2008-010972, filed on January 21; the entire contents of which are incorporated herein by reference.

The present invention relates to a solar cell module including a plurality of solar cells arranged in a predetermined direction, and wiring members connecting the plurality of solar cells to each other.

Solar cells directly convert clean and unlimitedly-supplied sunlight into electricity, and thus are expected as one of new energy sources.

In general, energy output per solar cell is approximately several watts. Accordingly, when solar cells are used as a power source for a house, a building or the like, a solar cell module is used in which the plurality of solar cells are electrically connected to each other to enhance energy output.

A solar cell module includes a solar cell string sealed by a sealing member between a light-receiving-surface-side protection member and a back-surface-side protection member. The solar cell string indicates the plurality of solar cells electrically connected to each other by conductive wiring members. The wiring members are connected to connecting electrodes included in the plurality of solar cells.

Here, there has been known a solar cell string formed by using back contact solar cells in each of which both p-side and n-side connecting electrodes are formed on a back surface provided on the opposite side of a light-receiving surface (See, for example, Japanese Patent Application Publication No. 2005-191479 (Patent Document 1)).

Such a solar cell string using back contact solar cells is manufactured in the following manner. Firstly, the plurality of solar cells are arranged in a predetermined arrangement direction. Next, a wiring member is connected to an n-side connecting electrode of one solar cell and to a p-side connecting electrode of another solar cell adjacent to the one solar cell. Here, assume that a first connecting point indicates a position where the wiring member is connected to the n-side connecting electrode of the one solar cell, and that a second connecting point indicates a position where the wiring member is connected to the p-side connecting electrode of the another solar cell. In the above solar cell string, the fist connecting point and the second connecting point are located on a line substantially parallel to the arrangement direction. In this way, the gap between the one and the another solar cells is fixed, thereby restricting the one and the another solar cells from moving in the arrangement direction.

A light-receiving-surface-side protection member, a back-surface-side protection member, and a sealing member constituting a solar cell module repeat expansion and contraction due to temperature changes in a use environment of the solar cell module. At this time, since thermal expansion coefficients respectively of the light-receiving-surface-side protection member, the back-surface-side protection member and the sealing member differ from one another, stress is generated in the arrangement direction.

Here, in Patent Document 1, since the gap between adjacent solar cells is fixed, the stress thus generated in the arrangement direction is concentrated on the first and second connecting points. If such stress is kept concentrated on the connecting points, damage is accumulated on connecting portions of the connecting electrodes and the wiring member. This damage causes poor connection between the connecting electrodes and the wiring member, thus resulting in a problem of a decrease in power collection efficiency of the solar cell module.

The present invention has been made in view of the above-described problem. An aim of the present invention is to provide a solar cell module which may suppress the decrease in power collection efficiency of the solar cell module.

A solar cell module according to an aspect of the present invention includes: a first solar cell (a solar cell 10a) and a second solar cell (a solar cell 10b) arranged in a first direction; and a wiring member (a wiring member 20) configured to electrically connect the first and second solar cells. In the solar cell module, the first and second solar cells each include: a light-receiving surface receiving light; a back surface provided on the opposite side of the light-receiving surface; and p-side electrodes (p-side connecting electrodes 14, 14a, and 14b) and n-side electrodes (n-side connecting electrodes 16, 16a, 16b, and 16c) formed on the back surface, the wiring member is connected to the n-side electrodes of the first solar cell at first connecting points (first connecting points 31, 31a, 31b, and 31c), and is connected to the p-side electrodes of the second solar cell at second connecting points (second connecting points 32, 32a, and 32b), and pairs of the first and second connecting points are respectively located on lines (first to third lines 41 to 43) intersecting with the first direction in a planar view of the back surface.

According to the aspect of the present invention, the first connecting point and a second connecting point are located on a line intersecting with the first direction. Accordingly, the wiring member is deformed when stress to move the first solar cell or the second solar cell in the first direction is applied. The deformation of the wiring member allows the first solar cell or the second solar cell to move in a direction in which the stress is applied. Thus, the stress thus generated can be prevented from being concentrated on the first and second connecting points. Accordingly, damage to be accumulated on the first and second connecting points can be reduced, thereby suppressing poor connection between the wiring member and the n-side electrode of the first solar cell, and between the wiring member and the p-side electrode of the second solar cell. Consequently, a decrease in power collection efficiency of the solar cell module can be suppressed.

In the aspect of the present invention, the wiring member may extend in a second direction which is substantially perpendicular to the first direction,

In the aspect of the present invention, the wiring member may include, in the planar view of the back surface, first protruding portions (first protruding portions 21a) protruding toward the first solar cell in the first direction, and second protruding portions (second protruding portions 21b) protruding toward the second solar cell in the first direction, and that the first connecting points be provided on the first protruding portions and the second connecting points be provided on the second protruding portions, respectively.

In the aspect of the present invention, the wiring member may include slit portions (slit portions 22) which penetrate the wiring member from one of two main planes of the wiring member to the other main plane of the wiring member, the two main planes being substantially in parallel to the back surface of the solar cell and being opposed to each other.
In the drawings
Fig. 1 is a side view of a solar cell module 100 according to a first embodiment of the present invention;
Figs. 2A to 2C are views for explaining the configuration of a solar cell 10 according to the first embodiment of the present invention;
Fig. 3 is a partially-enlarged view of Fig. 2C;
Fig. 4 is a plane view of a solar cell string 1 according to the first embodiment of the present invention seen from the back surface aide;
Figs. 5A and 5B are views each illustrating how a wiring member 20 is deformed;
Fig. 6 is a plane view of a solar cell string 1 according to a second embodiment of the present invention seen from the back surface side;
Fig. 7 is a plane view of a solar cell string 1 according to a modified example of the second embodiment of the present invention seen from the back surface side;
Figs. 8A and 8B are plane views of a solar cell string 1 according to a third embodiment of the present invention seen from the back surface side; and
Fig. 9 is a plane view of a solar cell string 1 according to another embodiment of the present invention seen from the back surface side.

Embodiments of the present invention will be described below by referring to the drawings. In the following description of the drawings, same or similar reference numerals are given to denote same or similar portions in the drawings. Note that the drawings are merely schematically shown and proportions of sizes and the like are different from actual ones. Thus, specific sizes and the like should be judged by referring to the description below. Needless to say, there are portions where relationships or proportions of sizes of the drawings are different from one another.

### [First Embodiment]

### <Schematic Configuration of Solar Cell Module>

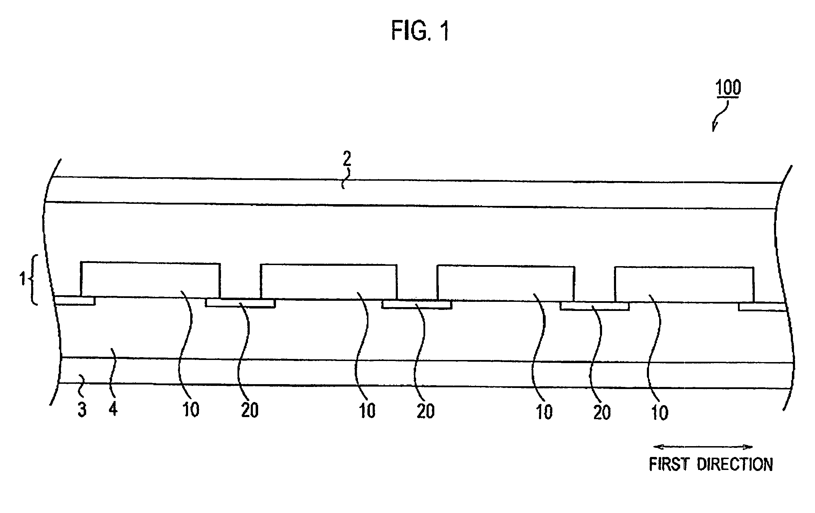

A schematic configuration of a solar cell module according to a first embodiment of the present invention will be described below by referring to Fig. 1. Fig. 1 is a side view of a solar cell module 100 according to the first embodiment of the present invention.

As shown in Fig. 1, the solar cell module 100 includes a solar cell string 1, a light-receiving-surface-side protection member 2, a back-surface-side protection member 3, and a sealing member 4.

The solar cell string 1 includes the plurality of solar cells 10 and the plurality of wiring members 20. The solar cell string 1 is configured in such a way that the plurality of solar cells 10 arranged in a first direction are electrically connected to each other through the plurality of wiring members 20. Each solar cell 10 has a light-receiving surface (upper surface in Fig. 1) receiving sunlight and a back surface (lower surface in Fig. 1) provided on the opposite side of the light-receiving surface. Each wiring member 20 is connected to the back surface of a first solar cell 10, and to the back surface of a second solar cell 10 adjacent to the first solar cell 10. A detailed configuration of the solar cell string 1, the solar cell 10 and the wiring member 20 will be described later.

The light-receiving-surface-side protection member 2 protects the light-receiving surface of the solar cell module 100, the light-receiving surface being the surface through which the solar cell module 100 receives sunlight. A translucent material such as glass can be used as the light-receiving-surface-side protection member 2.

The back-surface-side protection member 3 protects the back surface of the solar cell module 100, the back surface being provided on the opposite side of the light-receiving surface of the solar cell module 100. As the back-surface-side protection member 3, a weather-resistant resin film such as polyethylene terephthalate (PET), a laminated film having such a configuration in which aluminum foil is sandwiched between resin films, or the like can be used.

The sealing member 4 seals the solar cell string 1 between the light-receiving-surface-side protection member 2 and the back-surface-side protection member 3. A resin material such as EVA can be used as the sealing member 4.

### <Configuration of Solar Cell>

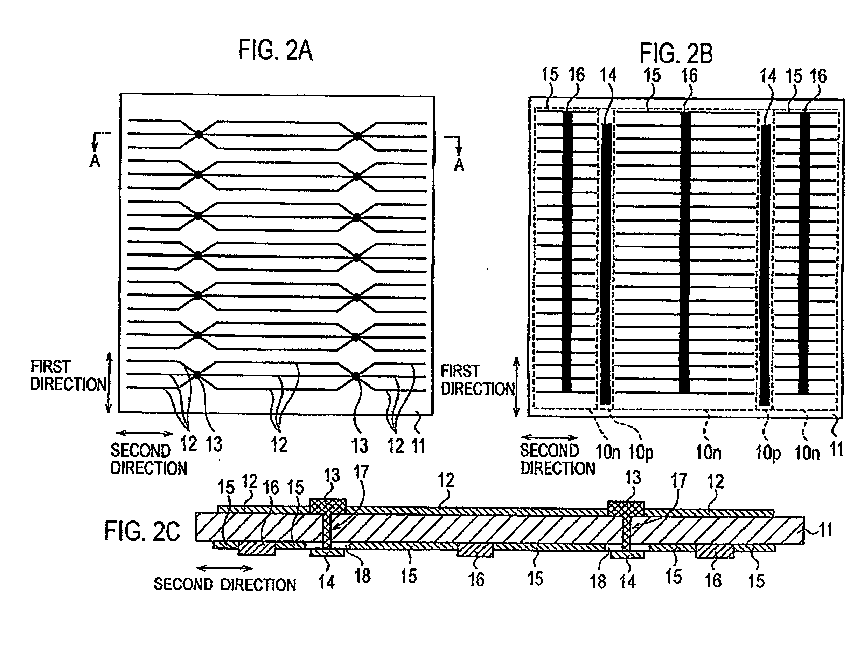

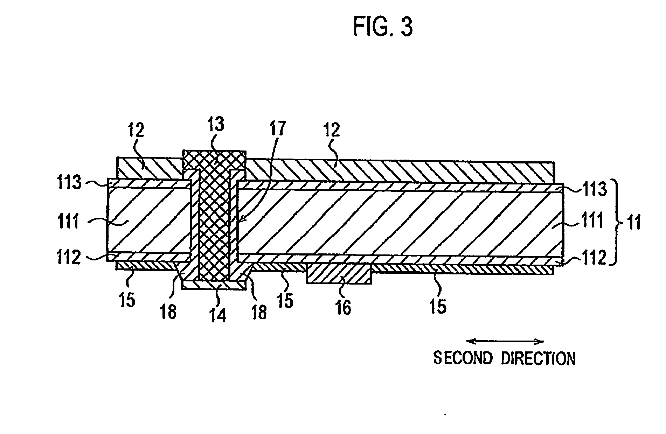

Next, the configuration of the solar cell 10 will be described by referring to Figs. 2A, 2B, 2C and 3. Fig. 2A is a plane view of the solar cell 10 seen from the light-receiving surface side. Fig. 2B is a plane view of the solar cell 10 seen from the back surface side. Fig. 2C is a cross-sectional view taken along the line A-A of Fig. 2A.

The solar cell 10 includes, a photoelectric conversion body 11 including semiconductor substrate, for example, an n-type semiconductor substrate, the plurality of p-side finer line-shaped electrodes 12, the plurality of through-hole electrodes 13, two p-side connecting electrodes 14, the plurality of n-side finer line-shaped electrodes 15, and three n-side connecting electrodes 16.

The photoelectric conversion body 11 is formed by using an n-type semiconductor substrate, and generates carriers when receiving light from the light-receiving surface side. A carrier denotes a pair of a hole and an electron, which is generated when the photoelectric conversion body 11 absorbs sunlight.

The p-side finer line-shaped electrodes 12 are collecting electrodes for collecting carriers (holes) from the photoelectric conversion body 11. As shown in Fig. 2A, the p-side finer line-shaped electrodes 12 are each formed on the light-receiving surface in a line extending in a second direction substantially perpendicular to the first direction in which the solar cells 10 are arranged. Moreover, the p-side finer line-shaped electrodes 12 are arranged in parallel to each other at predetermined intervals. The p-side finer line-shaped electrodes 12 can be formed by a printing method by using, for example, a sintered conductive paste or a thermoset conductive paste.

The through-hole electrodes 13 are collecting electrodes for further collecting the carriers collected by the p-side finer line-shaped electrodes 12 from the photoelectric conversion body 11. As shown in Fig. 2A, the through-hole electrodes 13 are dotted about like nodes. Specifically, the through-hole electrodes 13 are formed in two lines in the form of a dotted line in the first direction. Each through-hole electrode 13 is in contact with three p-side finer line-shaped electrodes 12. The through-hole electrodes 13 can be formed of a conductive material similar to that used for the p-side finer line-shaped electrodes 12.

The through-hole electrodes 13 are filled up in through-holes 17 shown in Fig. 2C, respectively, and reach to the back surface. The through-holes 17 penetrate the photoelectric conversion body 11 (including the n-type semiconductor substrate) from the light-receiving surface to the back surface. Such through-holes 17 can be formed by wet etching using a mixture of hydrofluoric acid and nitric acid, by dry etching using Cl₂, CCl₄, or BCl₃, by ion milling using Ar⁺ or the like, by laser processing using a YAG laser, or the like.

The p-side connecting electrodes 14 are electrodes for connecting the wiring members 20 to the solar cells 10. The p-side connecting electrodes 14 are electrically connected to all the p-side finer line-shaped electrodes 12 formed on the light-receiving surface through the through-hole electrodes 13.

Moreover, as shown in Fig. 2B, the p-side connecting electrodes 14 are formed respectively in two p-type regions 10p formed on the back surface in the first direction. In other words, the p-side connecting electrodes 14 are formed in two lines in the first direction. The p-side connecting electrodes 14 can be formed of a conductive material similar to that used for the p-side finer line-shaped electrodes 12.

The n-side finer line-shaped electrodes 15 are collecting electrodes for collecting carriers (electrons) from the photoelectric conversion body 11. As shown in Fig. 2B, the n-side finer line-shaped electrodes 15 are formed in n-type regions 10n formed on the back surface in the first direction. Here, the n-type regions 10n sandwich each p-type region 10p therebetween. In other words, the n-type regions 10n composed of three regions on the back surface. The n-side finer line-shaped electrodes 15 are each formed in the n-type region 10n in a line extending in the second direction. Moreover, the n-side finer line-shaped electrodes 15 are arranged in parallel to each other at predetermined intervals. Here, the n-side finer line-shaped electrodes 15 do not intersect with the p-side connecting electrodes 14. To put it another way, the p-side connecting electrodes 14 and the n-side finer line-shaped electrodes 15 are electrically isolated from each other. The n-side finer line-shaped electrodes 15 can be formed of a conductive material similar to that used for the p-side finer line-shaped electrodes 12.

As shown in Fig. 2B, the n-side connecting electrodes 16 are formed respectively in the n-type regions 10n formed on the back surface in the first direction. In other words, the n-side connecting electrodes 16 are formed in three lines in the first direction. Thus, the n-side connecting electrodes 16 intersect with, and are electrically connected to, the n-side finer line-shaped electrodes 15. The n-side connecting electrodes 16 can be formed of a conductive material similar to that used for the p-side finer line-shaped electrodes 12.

Fig. 3 is a partially-enlarged view of Fig. 2C. As shown in Fig. 3, the photoelectric conversion body 11 includes an n-type crystalline Si substrate 111, an n-type semiconductor layer 112, and a p-type semiconductor layer 113.

The n-type crystalline Si substrate 111 generates carriers (electrons and holes) by absorbing sunlight.

The n-type semiconductor layer 112 is formed on the back surface side of the n-type crystalline Si substrate 111. The n-type semiconductor layer 112 collects electrons generated in the n-type crystalline Si substrate 111. An n-type amorphous Si layer or the like can be used as the n-type semiconductor layer 112.

The p-type semiconductor layer 113 is formed on the light-receiving surface side of the n-type crystalline Si substrate 111. The p-type semiconductor layer 113 collects holes generated in the n-type crystalline Si substrate 111. A p-type amorphous Si layer or the like can be used as the p-type semiconductor layer 113.

Note that, the n-type semiconductor layer 112 and the p-type semiconductor layer 113 may be formed of the same crystalline Si as that used for the n-type crystalline Si substrate 111. When the n-type semiconductor layer 112 and the p-type semiconductor layer 113 are formed of amorphous Si, an intrinsic i-type amorphous silicon layer may be inserted between the n-type semiconductor layer 112 and the n-type crystalline Si substrate 111, and between the p-type semiconductor layer 113 and the n-type crystalline Si substrate 111.

As shown in Fig. 3, the solar cell 10 further includes an insulating member 18.

The insulating member 18 is formed so as to cover the inner wall of the through-hole 17 penetrating the p-type semiconductor layer 113, the n-type crystalline Si substrate 111, and the n-type semiconductor layer 112. The insulating member 18 insulates the through-hole electrode 13 from the n-type crystalline Si substrate 111, the n-type semiconductor layer 112 and the n-side finer line-shaped electrodes 15.

### <Configuration of Solar Cell String>

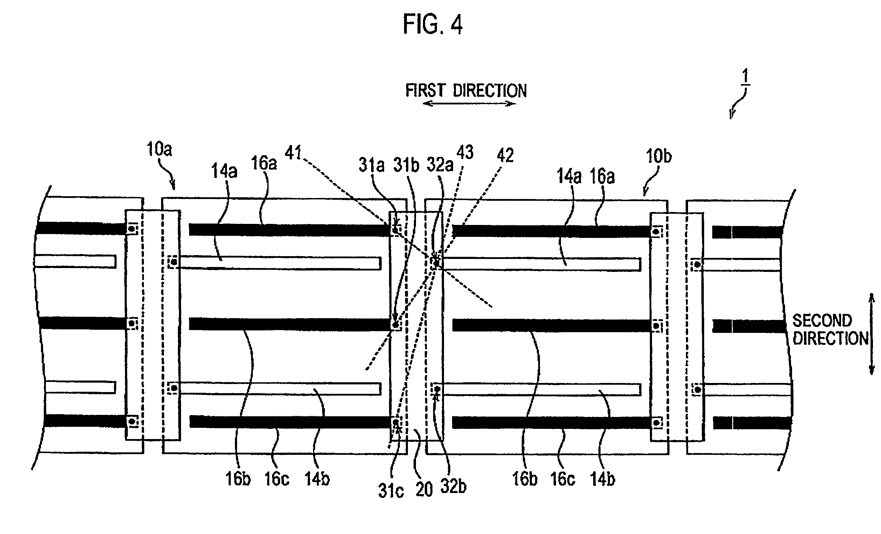

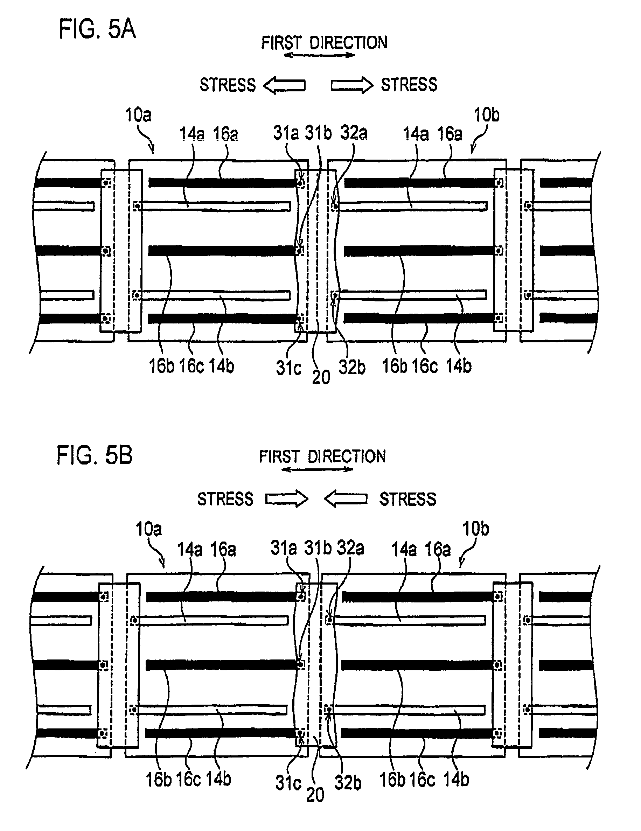

Next, the configuration of the solar cell string 1 will be described by referring to Figs. 4, 5A and 5B. Fig. 4 is a plane view of the solar cell string 1 seen from the back surface side. In Fig. 4, the n-side finer line-shaped electrodes 15 are omitted for simplifying the drawing.

As shown in Fig. 4, the solar cell string 1 includes the plurality of solar cells 10 (a solar cell 10a and a solar cell 10b) and wiring members 20.

The wiring members 20 extend in the second direction substantially perpendicular to the first direction. The wiring members 20 can be formed of a conductive material in the form of a thin-plate or the like.

The solar cell string 1 has such a configuration that the solar cell 10a and the solar cell 10b adjacent to the solar cell 10a are connected to each other through a wiring member 20. Specifically, the wiring member 20 is bonded to the n-side connecting electrodes 16 of the solar cell 10a, and to the p-side connecting electrodes 14 of the solar cell 10b by using a conductive adhesive such as solder. In this manner, the solar cell 10a and the solar cell 10b are electrically connected to each other in series through the wiring member 20. Hereinafter, a position where the wiring member 20 is connected to the n-side connecting electrode 16 of the solar cell 10a is referred to as a first connecting point 31. In the same way, a position where the wiring member 20 is connected to the p-side connecting electrode 14 of the solar cell 10b is referred to as a second connecting point 32.

Each pair of the first connecting point 31 and the second connecting point 32 are located in a line intersecting with the first direction.

Specifically, as shown in Fig. 4, a first connecting point 31a and a second connecting point 32a are located on a first line 41, the first connecting point 31a connecting an n-side connecting electrode 16a of the solar cell 10a and the wiring member 20, the second connecting point 32a connecting a p-side connecting electrode 14a of the solar cell 10b and the wiring member 20. The first line 41 is not parallel to the first direction, but extends in a direction intersecting with the first direction.

Meanwhile, a first connecting point 31b and the second connecting point 32a are located on a second line 42, the first connecting point 31b connecting an n-side connecting electrode 16b of the solar cell 10a and the wiring member 20. The second line 42 extends in a direction intersecting with the first direction, as similar to the first line 41.

Meanwhile, a first connecting point 31c and the second connecting point 32a are located on a third line 43, the first connecting point 31c connecting an n-side connecting electrode 16c of the solar cell 10a and the wiring member 20. The third line 43 extends in a direction intersecting with the first direction, as similar to the first line 41.

Although not shown in the drawing, the same configuration is also employed for a second connecting point 32b in which another p-side connecting electrode 14b is connected to the wiring member 20. Specifically, a pair of each of the first connecting points 31a to 31c and the second connecting point 32b are located on a line intersecting with the first direction. In essence, the first and second connecting points 31 and 32 are arranged in such a way that on a line substantially parallel to the first direction, none of the first connection points 31 is located together with either one of the second connection points 32.

### <Effects>

In the solar cell module 100 according to the first embodiment of the present invention, the wiring member 20 is connected to the n-side connecting electrodes 16 of the solar cell 10a at the first connecting points 31, and is connected to the p-side connecting electrodes 14 of the solar cell 10b adjacent to the solar cell 10a at the second connecting points 32. In addition, each pair of the first connecting point 31 and the second connecting point 32 is located in a line intersecting with the first direction.

Since the pair of the first connecting point 31 and the second connecting point 32 are located in a line intersecting with the first direction, the wiring members 20 are deformed when the solar cells 10 receive stress that will move the solar cells 10 in the first direction. More specifically, upon generation of stress that will expand the gap between the solar cells 10a and 10b in the first direction, the wiring member 20 curves in a waveform in a planar view seen from the back surface, as shown in Fig. 5A. Meanwhile, upon generation of stress that will reduce the gap between the solar cells 10a and 10b in the first direction, the wiring member 20 curves in a waveform in the plane view seen from the back surface, as shown in Fig. 5B.

The wiring member 20 is deformed in the above-described manners, so that the solar cells 10 can move in a direction in which the stress is applied. Thus, the stress thus generated can be prevented from being concentrated on the first and second connecting points 31 and 32. Accordingly, damage to be accumulated on the first and second connecting points 31 and 32 can be reduced, thereby suppressing poor connections between the wiring member 20 and the n-side connecting electrodes 16 of the solar cell 10a, and between the wiring member 20 and the p-side connecting electrodes 14 of the solar cell 10b. Consequently, a decrease in power collection efficiency of the solar cell module 100 can be suppressed.

Additionally, each wiring member 20 extends in the second direction substantially perpendicular to the first direction. Therefore, the wiring members 20 are prone to be deformed in the first direction. Thus, the stress generated can be more prevented from being concentrated on the first and second connecting points 31 and 32.

### [Second Embodiment]

A second embodiment of the present invention will be described below. Note that, in the following description, a difference between the first and second embodiments will be mainly described. A solar cell module 100 according to the second embodiment of the present invention has a schematic configuration similar to that of the solar cell module 100 shown in Fig. 1.

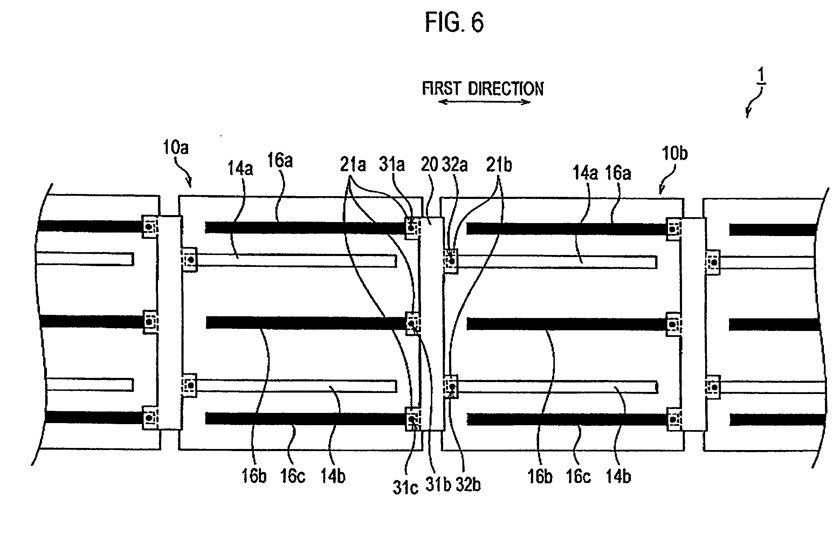

Fig. 6 is a plane view of a solar cell string 1 according to the second embodiment of the present invention seen from the back surface side. Note that, in Fig. 6, n-side finer line-shaped electrodes 15 are omitted for simplifying the drawing, as similar to Fig. 4.

As shown in Fig. 6, each wiring member 20 has first protruding portions 21a and second protruding portions 21b. The first protruding portions 21a protrude toward a solar cell 10a in the first direction. Meanwhile, the second protruding portions 21b protrude toward a solar cell 10b in the first direction.

First connecting points 31 connecting n-side connecting electrodes 16 of the solar cell 10a and the wiring member 20 are respectively provided on the first protruding portions 21a. Meanwhile, second connecting points 32 connecting p-slide connecting electrodes 14 of the solar cell 10b and the wiring member 20 are respectively provided on the second protruding portions 21b.

### <Effects>

In the solar cell module 100 according to the second embodiment of the present invention, the first connecting points 31 are respectively provided on the first protruding portions 21a, while the second connecting points 32 are respectively provided on the second protruding portions 21b.

With such a configuration, the width of each wiring member 20 in the first direction can be made small in parts other than where the wiring member 20 and the connecting electrodes 14 and 16 are connected with each other. Use of this configuration allows the wiring members 20 to be deformed more easily, and also allows the solar cells 10 to move more easily.

Thereby, generated stress can be further prevented from being concentrated on the first and second connecting points 31 and 32. Accordingly, poor connections between the wiring member 20 and the n-side connecting electrodes 16 of the solar cell 10a, and between the wiring member 20 and the p-side connecting electrodes 14 of the solar cell 10b can be further suppressed. Thus, the solar cell module 100 according to the second embodiment of the present invention can further suppress the decrease in power collection efficiency.

### [Modified Example of Second Embodiment]

In the second embodiment of the present invention, the description has been given of the case where the first and second protruding portions 21a and 21b each have a rectangular shape. However, the present invention is not limited to this.

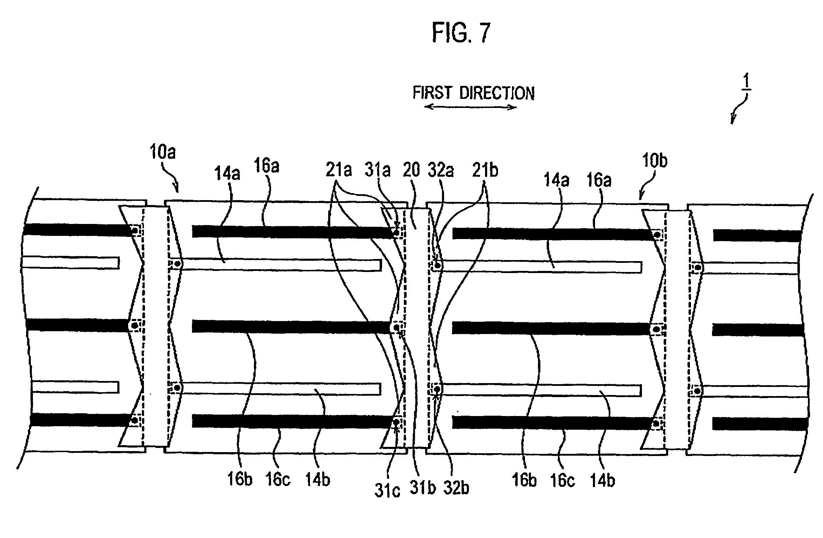

The configuration of a solar cell string 1 according to a modified example of the second embodiment will be described by referring to Fig. 7. A solar cell module 100 according to the modified example of the second embodiment also has a schematic configuration similar to that of the solar cell module 100 shown in Fig. 1.

Fig. 7 is a plane view of the solar cell string 1 according to the modified example of the second embodiment seen from the back surface side. Note that, in Fig. 7, n-side finer line-shaped electrodes 15 are omitted for simplifying the drawing, as similar to Fig. 4.

Each wiring member 20 has first protruding portions 21a and second protruding portions 21b. The first protruding portions 21a protrude toward a solar cell 10a in the first direction. Meanwhile, the second protruding portions 21b protrude toward a solar cell 10b in the first direction. Here, as shown in Fig. 7, the first protruding portions 21a each have a triangular shape with its apex on the solar cell 10a side, while the second protruding portions 21b each have a triangular shape with its apex on the solar cell 10b side.

An effect similar to the second embodiment of the present invention can be obtained by the solar cell module 100 according to this modified example. To be more specific, in the solar cell module 100 according to this modified example, the width of each wiring member 20 in the first direction can be made small. Use of this configuration allows the wiring members 20 to be deformed more easily, and also allows the solar cells 10 to move more easily.

Thereby, generated stress can be further prevented from being concentrated on the first and second connecting points 31 and 32. Accordingly, poor connections between the wiring member 20 and n-side connecting electrodes 16 of the solar cell 10a, and between the wiring member 20 and p-side connecting electrodes 14 of the solar cell 10b can be further suppressed. Thus, the solar cell module 100 according to the modified example of the second embodiment of the present invention can further suppress the decrease in power collection efficiency, as similar to the solar cell module 100 according to the second embodiment of the present invention. As has been described, according to the present invention, the decrease in power collection efficiency can be further suppressed irrespective of the shapes of the first and second protruding portions 21a and 21b.

### [Third Embodiment]

A third embodiment of the present invention will be described below. Note that, in the following description, a difference between the first and third embodiments will be mainly described. A solar cell module 100 according to the third embodiment of the present invention has a schematic configuration similar to that of the solar cell module 100 shown in Fig. 1.

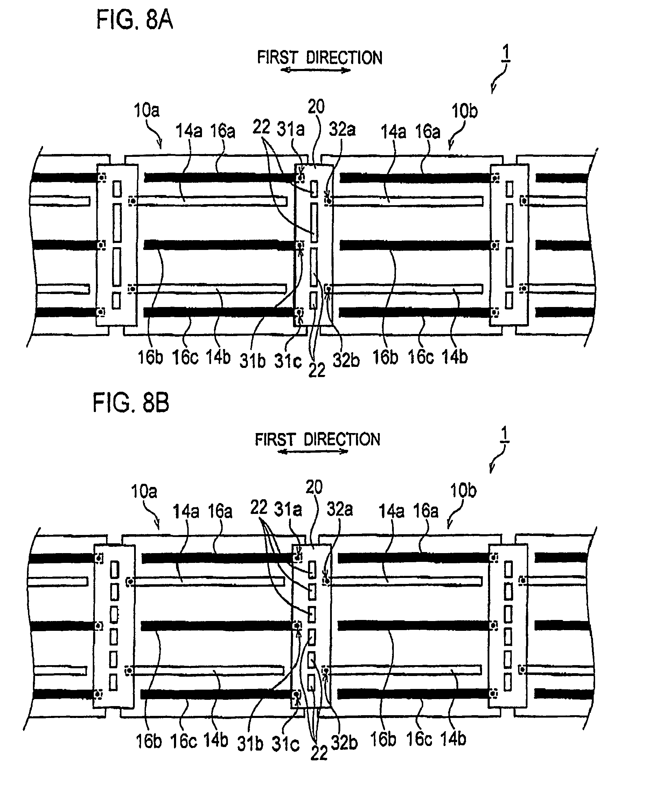

Figs. 8A and 8B are plane views of a solar cell string 1 according to the third embodiment of the present invention seen from the back surface side. Note that, in Fig. 8A and 8B, n-side finer line-shaped electrodes 15 are omitted for simplifying the drawing, as similar to Fig. 4.

As shown in Figs. 8A and 8B, each wiring member 20 includes slit portions 22 which penetrate the wiring member from one of two main planes of the wiring member substantially parallel to the back surfaces of solar cells 10 to the other main plane of the wiring member provided on the opposite side of the one of the two main planes. The sizes of the slit portions 22 may differ from one another, as shown in Fig. 8A, or may be substantially similar to one another, as shown in Fig. 8B. The slit portions 22 are preferably arranged on the lines different from the lines where first and second connecting points 31 and 32 are arranged, the lines being substantially parallel to the first direction. It should be noted that, although four of the slit portions 22 are provided in Fig. 8A and six of the slit portions 22 are provided in Fig. 8B, the number of the slit portions 22 is not limited to these. Moreover, although the slit portions 22 are rectangular in shape in Figs. 8A and 8B, the shape of the slit portion 22 is not limited to this.

### <Effects>

In the solar cell module 100 according to the third embodiment of the present invention, each wiring member 20 is provided with the slit portions 22 penetrating the wiring member 20.

Use of this configuration allows the wiring members 20 to be deformed more easily, and also allows the solar cells 10 to move more easily. Thereby, generated stress can be further prevented from being concentrated on the first and second connecting points 31 and 32. Accordingly, poor connections between the wiring member 20 and n-side connecting electrodes 16 of a solar cell 10a, and between the wiring member 20 and p-side connecting electrodes 14 of a solar cell 10b can be further suppressed. Thus, the solar cell module 100 according to the third embodiment of the present invention can further suppress the decrease in power collection efficiency.

### [Other Embodiments]

The present invention has been described by using the above-described embodiments. However, it should be understood that those descriptions and drawings constituting a part of the present disclosure do not limit the present invention. Various alternative embodiments, examples, and operational techniques will be apparent to those skilled in the art from the present disclosure.

For example, in the first to third embodiments described above, each photoelectric conversion body 11 includes the n-type semiconductor substrate. Alternatively, the photoelectric conversion body 11 may include the p-type semiconductor substrate.

Moreover, in the first to third embodiments, the n-type semiconductor layer 112 is formed on the back surface side of the photoelectric conversion body 11, and the p-type semiconductor layer 113 is formed on the light-receiving surface side of the photoelectric conversion body 11. Instead, the p-type semiconductor layer 113 may be formed on the back surface side of the photoelectric conversion body 11, and the n-type semiconductor layer 112 may be formed on the light-receiving surface side of the photoelectric conversion body 11.

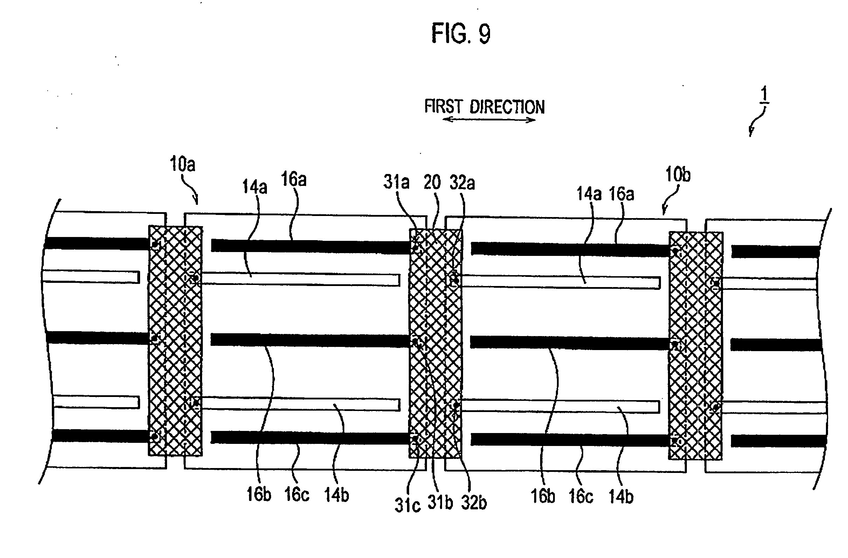

Further, although each wiring member 20 is in the form of a thin-plate in the first to third embodiments, the present invention is not limited to this. Specifically, as shown in Fig. 9, the wiring member 20 can be formed of a mesh-shaped conductive material. Alternatively, line-shaped conductive materials tied in a bundle may also be employed as the wiring member 20.

Furthermore, although each solar cell 10 is provided with the through-hole electrodes 13 in the first to third embodiments, the present invention is not limited to this. The present invention is applicable as long as both of the p-side and n-side connecting electrodes 14 and 16 are formed on the back surface of the solar cell 10.

Furthermore, although the wiring member 20 has a rectangular shape in the first to third embodiments, the present invention is not limited to this.

**Additional features of the invention are discussed in the following clauses:**
1. A solar cell module comprising:
   first and second solar cells arranged in a first direction; and
   a wiring member configured to electrically connect the first and second solar cells, wherein
   the first and second solar cells each include:
      a light-receiving surface;
      a back surface provided on the opposite side of the light-receiving surface; and
      p-side and n-side electrodes formed on the back surface,
   the wiring member is connected to the n-side electrode of the first solar cell at a first connecting point, and is connected to the p-side electrode of the second solar cell at a second connecting point, and
   in a planar view of the back surface, the first and second connecting points are located on a line intersecting with the first direction.
2. The solar cell module according to clause 1, wherein
   the wiring member extends in a second direction which is substantially perpendicular to the first direction.
3. The solar cell module according to clause 1, wherein
   in the planar view of the back surface, the wiring member includes a first protruding portion protruding toward the first solar cell along the first direction, and a second protruding portion protruding toward the second solar cell along the first direction,
   the first connecting point is provided on the first protruding portion, and
   the second connecting point is provided on the second protruding portion.
4. The solar cell module according to clause 1, wherein
   the wiring member includes a slit portion which penetrates the wiring member from one of two main planes of the wiring member to the other main plane of the wiring member, the two main planes being substantially in parallel to the back surface of the solar cell and being opposed to each other.

## Claims

1. A solar cell module comprising:
first and second solar cells arranged in a first direction; and
a wiring member configured to electrically connect the first and second solar cells, wherein
the first and second solar cells each include:
a light-receiving surface;
a back surface provided on the opposite side of the light-receiving surface; and
p-side and n-side electrodes formed on the back surface, the wiring member is connected to the n-side electrode of the first solar cell at a first connecting point, and is connected to the p-side electrode of the second solar cell at a second connecting point, and the wiring member is formed of a mesh-shaped conductive material.

2. The solar cell module according to claim 1, wherein in a planar view of the back surface, the first and second connecting points are located on a line intersecting with the first direction.

3. The solar cell module according to claim 1, wherein
in the planar view of the back surface, the wiring member includes a first protruding portion protruding toward the first solar cell along the first direction, and a second protruding portion protruding toward the second solar cell along the first direction,
the first connecting point is provided on the first protruding portion, and
the second connecting point is provided on the second protruding portion.

4. The solar cell module according to claim 1, wherein
the wiring member extends in a second direction which is substantially perpendicular to the first direction.
